(19) Europäisches Patentamt
European Patent Office
Office européen des brevets

(11) **EP 3 748 775 B1**

(12) **EUROPÄISCHE PATENTSCHRIFT**

(45) Veröffentlichungstag und Bekanntmachung des Hinweises auf die Patenterteilung:
**20.10.2021 Patentblatt 2021/42**

(51) Int Cl.:
*H01Q 21/24* *(2006.01)*     *G01R 29/08* *(2006.01)*
*H01Q 1/38* *(2006.01)*      *H01Q 7/00* *(2006.01)*
*H01Q 9/27* *(2006.01)*      *H01Q 21/06* *(2006.01)*
*H01Q 9/06* *(2006.01)*

(21) Anmeldenummer: **20178410.5**

(22) Anmeldetag: **05.06.2020**

(54) **VORRICHTUNG UND VERFAHREN ZUR BESTIMMUNG DER POLARISATION EINER ELEKTROMAGNETISCHEN WELLE**

DEVICE AND METHOD FOR DETERMINING THE POLARISATION OF AN ELECTROMAGNETIC WAVE

DISPOSITIF ET PROCÉDÉ DE DÉTERMINATION DE LA POLARISATION D'UNE ONDE ÉLECTROMAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.06.2019 DE 102019208358**

(43) Veröffentlichungstag der Anmeldung:
**09.12.2020 Patentblatt 2020/50**

(73) Patentinhaber:
• **Technische Universität Dortmund**
  **44227 Dortmund (DE)**
• **Technische Universität Dresden**
  **01069 Dresden (DE)**

(72) Erfinder:
• **Neumann, Niels**
  **01159 Dresden (DE)**
• **Mai, Carsten**
  **44227 Dortmund (DE)**
• **Laabs, Martin**
  **01097 Dresden (DE)**
• **Plettemeier, Dirk**
  **01187 Dresden (DE)**

(74) Vertreter: **Pfenning, Meinig & Partner mbB**
  **Patent- und Rechtsanwälte**
  **An der Frauenkirche 20**
  **01067 Dresden (DE)**

(56) Entgegenhaltungen:
**US-A- 3 836 973     US-A- 4 588 993**

**Beschreibung**

Die Erfindung betrifft eine Vorrichtung und ein Verfahren zur Bestimmung der Polarisation elektromagnetischer Wellen mittels einer Antennenanordnung und Detektionselementen auf einem Substrat.

Für vergleichsweise niedrige Funkfrequenzen, typischerweise unterhalb des Millimeterwellen- und Submillimeterwellenbereiches <30 GHz, sowie für Licht sind verschiedene Vorrichtungen und Verfahren zur Bestimmung der Polarisation bekannt. Für den höherfrequenten Millimeterwellen- und Submillimeterwellenbereich, auch THz-Strahlung genannt, ist jedoch die Polarisationsbestimmung bislang kaum möglich.

Zur Polarisationsbestimmung von Licht werden Polarisationsfilter verwendet, mit denen einzelne Komponenten des Lichtes herausgefiltert werden, um ihren Anteil am einfallenden Licht zu bestimmen. Für elektromagnetische Strahlung mit längeren Wellenlängen und geringerer Photonenenergie ist das Design optischer Vorrichtungen mit derartigen Filtern jedoch problematisch. Auf Grund der hohen Anzahl und großen Abmessungen der optischen und mechanisch bewegten Elemente in einer solchen Vorrichtung sowie deren feiner, fehleranfälliger Justierung kann weder eine hohe Messgenauigkeit erreicht werden, noch können Vorrichtungen realisiert werden, die einfach transportabel und platzsparend sind und sich somit auch für ortsaufgelöste Messungen eignen.

Aus US 3,836,973 A ist außerdem ein Verfahren zur Polarisationsbestimmung bekannt, für das unterschiedlich polarisierte Antennen verwendet werden. Bei diesem Verfahren wird das Signal einer elektromagnetischen Strahlung von zwei kreuzpolarisierte Antennen empfangen und auf eine Zwischenfrequenz gemischt. Die Polarisation der elektromagnetischen Strahlung wird aus den dabei auftretenden Phasenverschiebungen zwischen den horizontal und vertikal polarisierten Komponenten sowie deren Amplituden bestimmt.

Für hochfrequente elektromagnetische Strahlung ist ein solches Verfahren jedoch nicht praktikabel, da keine geeigneten Mischer für die Erzeugung der Zwischenfrequenz zur Verfügung stehen. Bei hohen Frequenzen ist der aufzulösende Zeitunterschied einer Phasenverschiebung sehr gering, bei einer Trägerfrequenz von 1 THz und einer Phasenverschiebung von 90° beträgt der Zeitunterschied beispielsweise nur 250 fs. Daher verursachen bereits geringes Phasenrauschen oder Schwankungen der Phase, z.B. durch thermisch bedingte Weglängenunterschiede beim Erzeugen der Zwischenfrequenz, signifikante Fehler in der Polarisationsbestimmung, sodass das Verfahren für Frequenzen über ca. 30 GHz nicht geeignet ist.

Der vorliegenden Erfindung liegt daher die Aufgabe zugrunde, eine Vorrichtung und ein Verfahren vorzuschlagen, mit denen die genannten Nachteile überwunden werden, und die Polarisation von elektromagnetischen Wellen ohne mechanisch bewegte Teile in einfacher Weise bestimmt werden kann.

Diese Aufgabe wird erfindungsgemäß gelöst durch eine Vorrichtung nach Anspruch 1 und ein Verfahren nach Anspruch 10. Vorteilhafte Ausgestaltungen und Weiterbildungen sind in den abhängigen Ansprüchen beschrieben.

Eine Vorrichtung zur Bestimmung der Polarisation elektromagnetischer Wellen weist eine erste Anordnung von mindestens sechs Antennen und mindestens sechs Leistungsdetektoren sowie eine Auswerteeinheit auf. Die sechs Antennen und die sechs Leistungsdetektoren sind dabei flächig auf einer Oberfläche eines Substrates angeordnet oder in ein Substrat eingebracht, und jede der sechs Antennen ist genau einem der sechs Leistungsdetektoren zugeordnet.

Eine erste Antenne und ein dieser ersten Antenne zugeordneter erster Leistungsdetektor der Anordnung sind ausgebildet, bei Bestrahlung der ersten Antenne mit mindestens einer elektromagnetischen Welle die Leistung einer horizontal linear polarisierten Komponente dieser einfallenden elektromagnetischen Welle zu detektieren, und eine zweite Antenne und ein zweiter Leistungsdetektor der Anordnung sind ausgebildet, bei Bestrahlung der zweiten Antenne mit der mindestens einen elektromagnetischen Welle die Leistung einer vertikal linear polarisierten Komponente der einfallenden elektromagnetischen Welle zu detektieren.

Eine dritte Antenne und ein dritter Leistungsdetektor sind ausgebildet, bei Bestrahlung der dritten Antenne mit der mindestens einen elektromagnetischen Welle die Leistung einer linkszirkular polarisierten Komponente der einfallenden elektromagnetischen Welle zu detektieren, und eine vierte Antenne und ein vierter Leistungsdetektor sind ausgebildet, bei Bestrahlung der vierten Antenne mit der mindestens einen elektromagnetischen Welle die Leistung einer rechtszirkular polarisierten Komponente der einfallenden elektromagnetischen Welle zu detektieren.

Eine fünfte Antenne und ein fünfter Leistungsdetektor sind ausgebildet, bei Bestrahlung der fünften Antenne mit der mindestens einen elektromagnetischen Welle die Leistung einer Komponente der einfallenden elektromagnetischen Welle zu detektieren, deren Polarisationsrichtung linear unter einem Winkel von +45° zur Polarisationsrichtung der vertikal linear polarisierten Komponente der einfallenden elektromagnetischen Welle polarisiert ist, und eine sechste Antenne und ein sechster Leistungsdetektor sind ausgebildet, bei Bestrahlung der sechsten Antenne mit der mindestens einen elektromagnetischen Welle die Leistung einer Komponente der einfallenden elektromagnetischen Welle zu detektieren, deren Polarisationsrichtung linear unter einem Winkel von -45° zur Polarisationsrichtung der vertikal linear polarisierten Komponente der einfallenden elektromagnetischen Welle polarisiert ist.

Außerdem ist die Auswerteeinheit der Vorrichtung ausgebildet, aus den jeweils detektierten Leistungen der mindestens sechs Antennen die Polarisation der mindestens einen einfallenden elektromagnetischen Welle zu bestimmen. Die Auswerteeinheit kann hierfür insbesondere als elektrische Schaltung ausgebildet sein und vorzugsweise geeignete Signalverstärker aufweisen. Sie kann außerdem einen Computer mit Analog-Digital-Wandlung, der bestimmten Kombinationen von Leistungen einen Polarisationszustand zuweisen kann, und bzw. oder ein Anzeigegerät, beispielsweise einen Monitor oder ein Display, für die Anzeige der Polarisation aufweisen.

Mit der erfindungsgemäßen Vorrichtung ist es somit möglich, die Polarisation einer elektromagnetischen Welle ohne eine räumliche Aufspaltung der elektromagnetischen Welle in mehrere Teilstrahlen zu bestimmen, sodass Fehler wie sie z. B. bei einer Verwendung von Strahlteilern oder optischen Polarisationsfiltern auftreten, vermieden werden können. Durch die starre Anordnung der mindestens sechs Antennen und mindestens sechs Leistungsdetektoren auf oder in einem gemeinsamen Substrat bzw. gemeinsamen Chip kann eine aufwändige Ausrichtung bzw. Justierung der einzelnen Komponenten entfallen. Die Vorrichtung ist dadurch einfach handhabbar und transportabel, sodass mit der Vorrichtung beispielsweise auch orts- oder winkelabhängige Polarisationsbestimmungen rasch und mit einer hohen Genauigkeit durchgeführt werden können.

Bei der Vorrichtung kann die Leistungsbestimmung mittels passiver elektrischer bzw. elektronischer Komponenten erfolgen. Typische Probleme, wie sie bei der Verwendung von aktiven Komponenten, wie z. B. Transistoren, auftreten, die eine geringe Stabilität und Arbeitsfrequenz aufweisen, können somit vermieden werden. Außerdem kann mit der Vorrichtung auf eine Umsetzung in eine Zwischenfrequenz und eine Phasen- bzw. Laufzeitmessung der elektromagnetischen Welle verzichtet werden, sodass auch Polarisationsbestimmungen im höherfrequenten Bereich des elektromagnetischen Spektrums möglich sind und sogar Polarisationsbestimmungen innerhalb von Nanosekunden durchführbar sind. Die Polarisationsbestimmungen kann somit auch für gepulste Signale im höherfrequenten Bereich der elektromagnetischen Strahlung, insbesondere für gepulste elektromagnetische Wellen im Frequenzbereich des elektromagnetischen Spektrums zwischen 30 GHz bis 5 THz, durchgeführt werden. Für diesen Frequenzbereich kann die Vorrichtung außerdem besonders kompakt und portabel ausgebildet werden.

Unter der Polarisation einer elektromagnetischen Welle werden dabei die Richtung bzw. der Drehsinn des elektrischen Feldes einer vollständig polarisierten einfallenden elektromagnetischen Welle verstanden. Die Vorrichtung kann jedoch auch ausgestaltet sein, die Polarisation einer teilweise polarisierten einfallenden elektromagnetischen Strahlung zu bestimmen, wobei unter der Polarisation die Polarisation des polarisierten Anteils der überlagerten, einfallenden elektromagnetischen Wellen bzw. der einfallenden, teilweise polarisierten elektromagnetischen Strahlung verstanden wird.

Unter der Leistung einer bestimmten Komponente der elektromagnetischen Welle bzw. Strahlung, die von einer Antenne empfangen und von einem Leistungsdetektor detektiert werden kann, kann auch die Pulsenergie bzw. Intensität der jeweiligen Komponente einer gepulsten einfallenden elektromagnetischen Welle bzw. Strahlung verstanden werden, die durch eine bestimmte Empfangsfläche der Antenne in die Antenne eingestrahlt wird. Die Leistung einer elektromagnetischen Welle kann aus dem Freiraum auf eine Antenne und den zugehörigen Leistungsdetektor eingestrahlt werden, oder alternativ aus dem Freiraum über ein abbildendes System mit einer Terahertz-Linse bzw. einer Substratlinse oder einem Fokussierspiegel auf eine Antenne und den zugehörigen Leistungsdetektor fokussiert werden.

Die mindestens sechs Antennen sind bevorzugt als planare Antennen ausgebildet und derart auf bzw. in dem Substrat angeordnet, dass die Flächennormalen der jeweiligen Empfangsflächen der Antennen, d. h. der Flächen, durch die die elektromagnetische Welle bzw. Strahlung an den Antennen empfangen wird, in die gleiche Richtung weisen. Die mindestens sechs Antennen und bzw. mindestens sechs Leistungsdetektoren können flächig auf der Oberfläche eines Substrates in direktem, also unmittelbar berührendem Kontakt zur Oberfläche des Substrates aufgebracht sein, oder in einer Ebene oder versetzt zueinander in das Substrat einbracht bzw. eingebettet sein. Sie können beispielsweise auf die Oberfläche des Substrates gedruckt oder abgeschieden sein oder monolithisch in das Substrat oder einen Schaltkreis auf dem Substrat integriert sein, d. h. als on-Chip-Antennen ausgebildet sein. Das Substrat kann insbesondere aus einem Halbleitermaterial, wie beispielsweise Silizium oder Werkstoffen der Gruppe III-V, wie z. B. GaAs oder InP, bestehen oder diese enthalten.

Bevorzugt weist die Anordnung der mindestens sechs Antennen und der mindestens sechs Leistungsdetektoren auch eine polarisationsinsensitive Referenzantenne und einen Referenzleistungsdetektor auf, die auf der Oberfläche des Substrats angeordnet sind oder in das Substrat eingebracht sind, wobei die Referenzantenne und der Referenzleistungsdetektor ausgebildet sind, bei Bestrahlung der Referenzantenne mit mindestens einer elektromagnetischen Welle die Gesamtleistung dieser einfallenden elektromagnetischen Welle zu detektieren. Die Referenzantenne und der Referenzleistungsdetektor können beispielsweise auf die Oberfläche des Substrates gedruckt oder abgeschieden sein oder monolithisch in das Substrat oder einen Schaltkreis auf dem Substrat integriert sein bzw. als on-Chip-Antennen ausgebildet sein.

Die Referenzantenne ist vorteilhaft als planare Empfangsantenne ausgebildet. Die Flächennormale der Empfangsfläche der Referenzantenne weist bevorzugt in die gleiche Richtung wie die Flächennormalen der Empfangsflächen der mindestens sechs Antennen der Anordnung. Die Referenzantenne kann somit dazu verwendet werden, mittels eines Abgleichs der an der Referenzantenne gemessenen Leistung mit den Leistungen, die an den mindestens sechs Antennen detektierten werden, den Polarisationsgrad der einfallenden elektromagnetischen Welle bzw. Strahlung zu bestimmen. Der Polarisationsgrad ist das Verhältnis der Leistung des polarisierten Anteils der einfallenden elektromagnetischen Welle bzw. Strahlung zur Gesamtleistung der einfallenden elektromagnetischen Welle bzw. Strahlung.

Besonders bevorzugt sind die erste Antenne, die zweite Antenne, die fünfte Antenne und sechste als Antennen desselben Typs ausgebildet und weisen Empfangsflächen auf, die gleichförmig ausgebildet sind und gleich groß sind, wobei die erste Antenne und die zweite Antenne zueinander orthogonal angeordnet sind, und die fünfte Antenne und die sechste Antenne zueinander orthogonal angeordnet sind, und die erste Antenne und die zweite Antenne paarweise orthogonal zu der fünften Antenne und der sechsten Antenne angeordnet sind. In einer Ausführungsform sind die erste, zweite, fünfte und sechste Antenne der mindestens sechs Antennen als Bow-tie-Antennen, insbesondere als Bow-tie-Antennen mit dreieckförmigen, winkelkonstanten Armen, ausgebildet, wobei die erste Antenne und die zweite Antenne zueinander orthogonal angeordnet sind, und die fünfte Antenne und die sechste Antenne zueinander orthogonal angeordnet sind, und die erste Antenne und die zweite Antenne paarweise orthogonal zu der fünften Antenne und der sechsten Antenne angeordnet sind.

In einer Ausführungsform sind die dritte Antenne und die vierte Antenne als Spiralantennen mit zueinander entgegengesetztem Drehsinn, insbesondere als zweiarmige, winkelkonstante, logarithmische Spiralantennen, ausgebildet. Bevorzugt sind die dritte Antenne und die vierte Antenne mit gleichgroßen Empfangsflächen ausgebildet.

In einer weiteren Ausführungsform ist die Referenzantenne als elektrisch kleine Antenne ausgebildet. Darunter soll insbesondere eine Antenne verstanden werden, deren Abmessungen der Empfangsfläche so viel kleiner als die Wellenlänge der einfallenden elektromagnetischen Wellen ausgebildet sind, dass die Antenne polarisationsunabhängig ist. Bevorzugt können die Abmessungen der Empfangsfläche kleiner als ein Fünftel, besonders bevorzugt kleiner als ein Zehntel der Wellenlänge der einfallenden elektromagnetischen Wellen betragen. In einer vorteilhaften Ausführungsform kann insbesondere der Referenzleistungsdetektor als Referenzantenne bzw. als eine elektrisch kleine Antenne ausgebildet sein, sodass ein besonders platzsparender und einfacher Aufbau der Vorrichtung erreicht werden kann.

Vorzugsweise sind die mindestens sechs Antennen und die sechs Leistungsdetektoren und bzw. oder die Referenzantenne und der Referenzleistungsdetektor ausgebildet, bei Bestrahlung mit mindestens einer elektromagnetischen Welle die Leistungen der jeweiligen Komponenten der einfallenden elektromagnetischen Welle in einem Frequenzbereich zwischen 30 GHz bis 5 THz, bevorzugt zwischen 50 GHz bis 5 THz, zu detektieren. Darunter soll insbesondere auch verstanden werden, dass die mindestens sechs Antennen und bzw. oder die Referenzantenne als breitbandige Antennen ausgebildet sind, die für elektromagnetische Strahlung in einem Frequenzbereich zwischen 30 GHz bis 5 THz, bevorzugt zwischen 50 GHz bis 5 THz empfindlich sind, wobei sich das Ausgangssignal der Antennen bei gleicher Eingangsleistung zwischen stärkstem und schwächsten Frequenzpunkt in einem Frequenzbereich zwischen 30 GHz bis 5 THz, bevorzugt zwischen 50 GHz bis 5 THz, typischerweise nicht mehr als 10 dB unterscheidet.

Somit kann mit der Vorrichtung insbesondere die Polarisation von Terahertz-Strahlung in einem Frequenzbereich zwischen 30 GHz bis 5 THz, bevorzugt zwischen 50 GHz bis 5 THz, bestimmt werden. Die maximale Größe der Antennen ist durch die untere Frequenz in diesem Frequenzbereich bestimmt, sodass die Vorrichtung für diesen Frequenzbereich sehr platzsparend und kompakt ausgebildet werden kann. Die Vorrichtung kann insbesondere als ein portables System-on-a-Chip bzw. Ein-Chip-System ausgebildet sein. Hierfür kann insbesondere auch die Auswerteeinheit auf dem Substrat bzw. Chip angeordnet sein. Mit der Vorrichtung können dadurch auch hoch ortsaufgelöste Polarisationsmessungen durchgeführt werden, da die gesamte Anordnung der Antennen und Leistungsdetektoren vollständig in den Strahl einer einfallenden elektromagnetischen Welle eingebracht werden kann.

Besonders bevorzugt sind die mindestens sechs Leistungsdetektoren und bzw. oder der Referenzleistungsdetektor der Vorrichtung ausgebildet, die Leistungen der jeweiligen Komponenten der einfallenden elektromagnetischen Welle in einer direkten Messung zu detektieren. Die Detektion der Leistungen kann inkohärent, also nicht heterodyn mittels Mischung auf Zwischenfrequenzen, erfolgen. Insbesondere sind die mindestens sechs Leistungsdetektoren und bzw. oder der Referenzleistungsdetektor als passive Detektoren, besonders bevorzugt als Schottky-Dioden-Detektoren, ausgebildet. Wenn ein von einer Antenne empfangenes Signal an einer Schottky-Barrieren-Diode eines Schottky-Dioden-Detektors angelegt wird, erzeugt die Schottky-Barrieren-Diode des Detektors einen Strom bzw. eine Spannung, die monoton abhängig von der Amplitude bzw. Leistung der Komponente der einfallenden elektromagnetischen Welle ist, die an der Antenne empfangen wird, sodass diese Leistung direkt erfasst werden kann. Für die Einkopplung des von der Antenne empfangenen Signals kann die Schottky-Barrieren-Diode des Detektors insbesondere als planare Schottky-Barrieren-Diode ausgebildet sein und monolithisch in die jeweilige Antenne integriert sein.

Die mindestens sechs Antennen und die mindestens sechs Leistungsdetektoren und bzw. oder die Referenzantenne und der Referenzleistungsdetektor können des Weiteren ausgebildet sein, bei Bestrahlung mit einer gepulsten elektromagnetischen Welle bzw. Strahlung die Leistungen der jeweiligen Komponente der einfallenden gepulsten elektromagnetischen Welle bzw. Strahlung zu detektieren. Insbesondere kann die Vorrichtung mit Leistungsdetektoren ausgebildet sein, die eine Antwortzeit unter einer Nanosekunde aufweisen. Somit kann die Polarisation jedes Pulses der einfallenden elektromagnetischen Welle einzeln bestimmt werden.

In einer Ausführungsform kann außerdem vorgesehen sein, dass die Vorrichtung mehrere Anordnungen von mindestens sechs Antennen und mindestens sechs Leistungsdetektoren zur Polarisationsbestimmung aufweist, und die Auswerteeinheit ausgebildet ist, die Polarisation mindestens einer auf die Anordnungen einfallenden elektromagnetischen Welle ortsaufgelöst in Abhängigkeit von der Position und Orientierung der Anordnungen der mindestens sechs Antennen zu bestimmen. Die Anordnungen der mindesten sechs Antennen und der mindestens sechs Leistungsdetektoren können auf einer Oberfläche eines Substrates angeordnet oder in ein Substrat eingebracht sein, es kann aber auch vorgesehen sein, dass die Vorrichtung mehrere Substrate mit mindestens einer Anordnung von mindestens sechs Antennen und mindestens sechs Leistungsdetektoren aufweist. Bevorzugt weisen die Flächennormalen der Empfangsflächen der mindestens sechs Antennen der jeweiligen Anordnungen in die gleiche Richtung, und die jeweils ersten, zweiten, dritten, etc. Antennen der Anordnungen sind derart angeordnet, dass sie jeweils in die gleiche Richtung orientiert sind.

Bei einem Verfahren zur Bestimmung der Polarisation einer elektromagnetischen Welle wird eine Anordnung aus mindestens sechs Antennen und mindestens sechs Leistungsdetektoren, von denen jeweils eine Antenne genau einem der Leistungsdetektoren zugeordnet ist, mit mindestens einer elektromagnetischen Welle bestrahlt. Mittels einer ersten Antenne und eines ersten Leistungsdetektors, die auf einer Oberfläche eines Substrates angeordnet oder in ein Substrat eingebracht sind, wird die Leistung einer horizontal linear polarisierten Komponente der einfallenden elektromagnetischen Welle detektiert und mittels einer zweiten Antenne und eines zweiten Leistungsdetektors, die auf der Oberfläche des Substrates angeordnet oder in das Substrat eingebracht sind, wird die Leistung einer vertikal linear polarisierten Komponente der einfallenden elektromagnetischen Welle detektiert.

Mittels einer dritten Antenne und eines dritten Leistungsdetektors, die auf der Oberfläche des Substrates angeordnet oder in das Substrat eingebracht sind, wird die Leistung einer linkszirkular polarisierten Komponente der einfallenden elektromagnetischen Welle detektiert und mittels einer vierten Antenne und eines vierten Leistungsdetektors, die auf der Oberfläche des Substrates angeordnet oder in das Substrat eingebracht sind, die Leistung einer rechtszirkular polarisierten Komponente der einfallenden elektromagnetischen Welle detektiert.

Außerdem wird mittels einer fünften Antenne und eines fünften Leistungsdetektors, die auf der Oberfläche des Substrates angeordnet oder in das Substrat eingebracht sind, die Leistung einer Komponente der einfallenden elektromagnetischen Welle detektiert, deren Polarisationsrichtung linear unter einem Winkel von +45° zur Polarisationsrichtung der vertikal linear polarisierten Komponente der einfallenden elektromagnetischen Welle polarisiert ist, und mittels einer sechsten Antenne und eines sechsten Leistungsdetektors, die auf der Oberfläche des Substrates angeordnet oder in das Substrat eingebracht sind, wird die Leistung einer Komponente der einfallenden elektromagnetischen Welle detektiert, deren Polarisationsrichtung linear unter einem Winkel von -45° zur Polarisationsrichtung der vertikal linear polarisierten Komponente der einfallenden elektromagnetischen Welle polarisiert ist.

Aus den jeweils detektierten Leistungen der mindestens sechs Antennen wird die Polarisation der einfallenden elektromagnetischen Welle bestimmt.

Das beschriebene Verfahren kann insbesondere mit der beschriebenen Vorrichtung durchgeführt werden, das heißt, die beschriebene Vorrichtung ist zum Durchführen des beschriebenen Verfahrens eingerichtet.

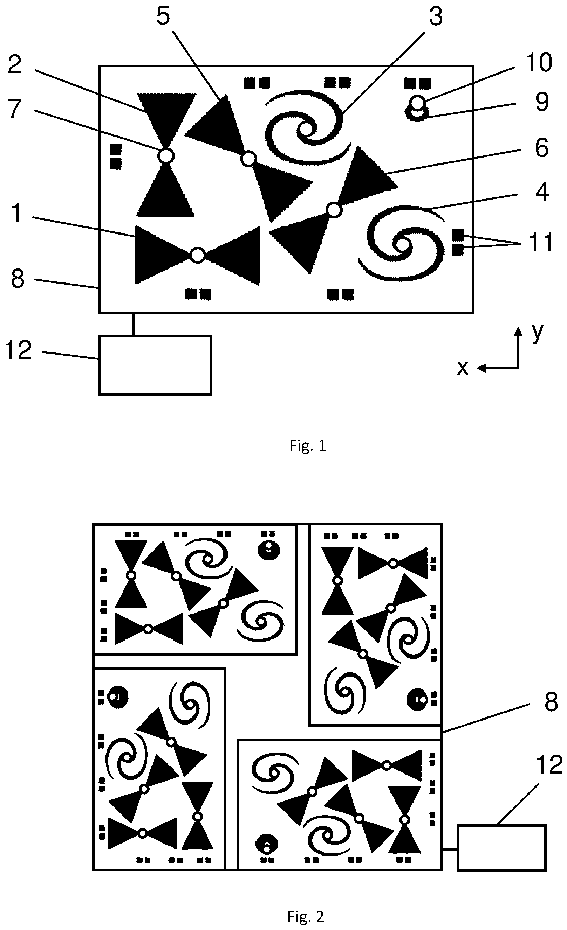

Ausführungsbeispiele der Erfindung sind in den Zeichnungen dargestellt und werden nachfolgend anhand der Figuren 1 und 2 erläutert.

Es zeigen:

Fig. 1    in einer schematischen Draufsicht ein Beispiel einer Antennenanordnung einer erfindungsgemäßen Vorrichtung zur Polarisationsbestimmung und

Fig. 2    in einer schematischen Draufsicht eine Vorrichtung mit mehreren Antennenanordnungen zur ortsaufgelösen Polarisationsbestimmung.

In Figur 1 ist in einer schematischen Draufsicht ein Beispiel einer Antennenanordnung einer Vorrichtung zur Polarisationsbestimmung dargestellt. Eine Vorrichtung weist eine erste Anordnung von mindestens sechs Antennen 1, 2, 3, 4, 5, 6 und mindestens sechs Leistungsdetektoren 7 sowie eine Auswerteeinheit 12 auf, wobei jede der sechs Antennen 1, 2, 3, 4, 5, 6 genau einem einzigen der sechs Leistungsdetektoren 7 zugeordnet ist. Die sechs Antennen 1, 2, 3, 4, 5, 6 und die sechs Leistungsdetektoren 7 sind flächig auf einer Oberfläche eines Substrates 8 angeordnet, können jedoch alternativ auch in das Substrat eingebracht sein, z.B. monolithisch in ein Substrat 8, insbesondere auch ein mehrschichtiges Substrat, integriert sein.

Die erste Antenne 1 und der erster Leistungsdetektor 7 sind ausgebildet, bei Bestrahlung der ersten Antenne 1 mit mindestens einer elektromagnetischen Welle die Leistung einer horizontal linear polarisierten Komponente dieser einfallenden elektromagnetischen Welle zu detektieren. Die zweite Antenne 2 und der zweiter Leistungsdetektor 7 der Anordnung sind ausgebildet, bei Bestrahlung der zweiten Antenne 2 mit der mindestens einer elektromagnetischen Welle die Leistung einer vertikal linear polarisierten Komponente der einfallenden elektromagnetischen Welle zu detektieren. Die dritte Antenne 3 und ein dritter Leistungsdetektor 7 sind ausgebildet, bei Bestrahlung der dritten Antenne 3 mit der mindestens einer elektromagnetischen Welle die Leistung einer linkszirkular polarisierten Komponente der einfallenden elektromagnetischen Welle zu detektieren, und die vierte Antenne 4 und ein vierter Leistungsdetektor 7 sind ausgebildet, bei Bestrahlung der vierten Antenne 4 mit der mindestens einer elektromagnetischen Welle die Leistung einer rechtszirkular polarisierten Komponente der einfallenden elektromagnetischen Welle zu detektieren. Die fünfte Antenne 5 und der fünfte Leistungsdetektor 7 sind ausgebildet, bei Bestrahlung der fünften Antenne 5 mit der mindestens einer elektromagnetischen Welle die Leistung einer Komponente der einfallenden elektromagnetischen Welle zu detektieren, deren Polarisationsrichtung linear unter einem Winkel von +45° zur Polarisationsrichtung der vertikal linear polarisierten Komponente der einfallenden elektromagnetischen Welle polarisiert ist, und die sechste Antenne 6 und der sechste Leistungsdetektor 7 sind ausgebildet, bei Bestrahlung der sechsten Antenne 6 mit der mindestens einen elektromagnetischen Welle die Leistung einer Komponente der einfallenden elektromagnetischen Welle zu detektieren, deren Polarisationsrichtung linear unter einem Winkel von -45° zur Polarisationsrichtung der vertikal linear polarisierten Komponente der einfallenden elektromagnetischen Welle polarisiert ist. Des Weiteren ist die Auswerteeinheit 12 ausgebildet, aus den detektierten Leistungen der mindestens sechs Antennen 1, 2, 3, 4, 5, 6 die Polarisation der mindestens einen einfallenden elektromagnetischen Welle, mit der die Anordnung bestrahlt wird, zu bestimmen. Die jeweils detektierten Leistungen können hierfür an Kontaktstellen 11 der jeweiligen Leistungsdetektoren als Messsignale abgegriffen und an die Auswerteeinheit 12 geleitet bzw. übertragen werden. Die Auswerteeinheit 12 ist über eine elektrische Verbindung mit den Kontaktstellen 11 bzw. den Leistungsdetektoren 7 verbunden.

Im dargestellten Beispiel sind die mindestens sechs Antennen 1, 2, 3, 4, 5, 6 als planare Antennen auf einem Gallium-Arsenid-Halbleitersubstrat 8 ausgebildet. Die erste Antenne 1, die zweite Antenne 2, die fünfte Antenne 5 und sechste Antenne 6 sind als flächengleiche Bow-tie-Antennen mit winkelkonstanten, dreieckförmigen Armen ausgebildet, während die dritte Antenne 3 und die vierte Antenne 4 als Spiralantennen mit zueinander entgegengesetztem Drehsinn ausgebildet sind. Die Vorrichtung weist außerdem auf der Oberfläche des Substrates 8 eine Referenzantenne 9 und einen Referenzleistungsdetektor 10 auf, die ausgebildet sind, die Gesamtleistung der einfallenden elektromagnetischen Welle, d. h. die Leistung des polarisierten und des unpolarisierten Anteils der einfallenden elektromagnetischen Welle zu detektieren. Die Referenzantenne 9 ist als polarisationsunabhängige, elektrisch kleine Antenne, im dargestellten Beispiel als Ringantenne mit integriertem Referenzleistungsdetektor 10, ausgebildet. Die Flächennormale der Empfangsfläche der ersten bis sechsten Antenne 1, 2, 3, 4, 5, 6 und der Referenzantenne 9 sind in die gleiche Richtung ausgerichtet.

Die erste bis sechste Antenne 1, 2, 3, 4, 5, 6 und die Referenzantenne 9 sowie die den Antennen zugeordneten Leistungsdetektoren 7 sind ausgebildet, die jeweiligen Komponenten einer einfallenden elektromagnetischen Welle im Frequenzbereich zwischen 30 GHz bis 5 THz zu empfangen und deren Leistung zu detektieren. Die sechs Antennen 1, 2, 3, 4, 5, 6, sechs Leistungsdetektoren 7, die Referenzantenne 9 und der Referenzleistungsdetektor 10 sind dabei typischerweise auf einer Fläche angeordnet, die kleiner als 5 x 10 mm$^2$ ist, sodass die Anordnung sehr kompakt und leicht zu transportieren ist.

Die Leistungsdetektoren 7 der ersten bis sechsten Antenne 1, 2, 3, 4, 5, 6 und der Referenzantenne 9 können prinzipiell zueinander verschieden ausgebildet sein, im dargestellten Beispiel sind sie als InGaAs/InP-Schottky-Dioden-Detektoren ausgebildet. Die Schottky-Barriere-Diode des jeweiligen Leistungsdetektors 7 ist hierfür in die jeweilige dem Leistungsdetektor 7 zugeordnete Antenne 1, 2, 3, 4, 5, 6, 9 integriert und kann bei Raumtemperatur betrieben werden. Mit den Leistungsdetektoren 7 können die Leistungen der an den jeweiligen Antennen 1, 2, 3, 4, 5, 6, 9 empfangenen Komponenten der einfallenden elektromagnetischen Welle direkt gemessen werden und als Messsignal über Kontaktstellen 11 am jeweiligen Leistungsdetektor 7 abgegriffen und an die Auswerteeinheit 12 geleitet werden. Die Kontaktstellen 11 sind über Vias (nicht gezeigt), d. h. über elektrisch leitfähige Verbindungen und bzw. oder Durchkontaktierungen, mit dem jeweiligen Leistungsdetektor 7 verbunden. Sie können außerdem ausgebildet sein, ein Bias-Signal, das von der Auswerteeinheit 12 individuellen für den jeweiligen Leistungsdetektor 7 bereitgestellt und vom empfangenen Messsignal getrennt werden kann, an den jeweiligen Leistungsdetektor 7 anzulegen.

Die Leistungsdetektoren 7 und der Referenzleistungsdetektor 10 sind so ausgebildet, dass sie eine Antwortzeit $\tau < 10^{-9}$ s aufweisen. Somit kann mit der Vorrichtung auch die Polarisation von gepulsten elektromagnetischen Wellen für einzelne Pulse bestimmt werden.

Die Auswerteeinheit ist ausgebildet, aus den Leistungen bzw. der Pulsenergie der jeweiligen Komponenten der elektromagnetischen Welle, die mit den sechs Antennen 1, 2, 3, 4, 5, 6 und den sechs Leistungsdetektoren 7 detektiert wurden, die Polarisation, d. h. den Polarisationszustand, der einfallenden elektromagnetischen Welle zu bestimmen. Jede Antenne 1, 2, 3, 4, 5, 6, 9 und der ihr jeweils zugeordnete Leistungsdetektor 7, 10 hat eine spezifische Responsivität, d. h. eine spezifische Abhängigkeit des am jeweiligen Leistungsdetektor 7, 10 gemessenen Ausgangssignals von der Leistung bzw. der Pulsenergie der einfallenden elektromagnetischen Welle. Um mittels der einzelnen gemessenen Ausgangssignale den Polarisationszustand bestimmen zu können, muss diese Abhängigkeit bekannt sein. Eine mögliche Kalibrier-Prozedur besteht darin, einmalig jede Antenne 1, 2, 3, 4, 5, 6, 9 und den ihr jeweils zugeordneten Leistungsdetektor 7, 10 mit elektromagnetischen Wellen, deren Polarisierung der Polarisierung der Antenne entspricht (d. h. linear horizontal polarisiert für Antenne 1, linear vertikal polarisiert für Antenne 2, usw.) mit unterschiedlichen, bekannten Leistungen zu bestrahlen und die an den jeweiligen Leistungsdetektoren 7, 10 gemessenen Ausgangssignale in Abhängigkeit von der Leistung der einfallenden elektromagnetischen Welle aufzuzeichnen. Mit dieser Wertezuordnung und ggf. Interpolation kann die Abhängigkeit des am jeweiligen Leistungsdetektor 7, 10 gemessenen Ausgangssignals von der Leistung der einfallenden elektromagnetischen Welle bestimmt werden, und somit in der Auswerteeinheit 12 dem am jeweiligen Leistungsdetektor 7, 10 gemessenen Ausgangssignal eindeutig eine Leistung einer einfallenden elektromagnetischen Welle zugeordnet werden. Im Folgenden wird auf die so bestimmten Leistungen Bezug genommen.

Bei vollständig polarisierten elektromagnetischen Wellen entspricht die Summe aller an den Leistungsdetektoren der Antennen 1, 2, 3, 4, 5, 6 detektierten Leistungen der Gesamtleistung der elektromagnetischen Welle. Bei unvollständig polarisierten elektromagnetischen Wellen kann die Gesamtleistung nur mit dem Referenzleistungsdetektor 10 bestimmt werden. Die an den Leistungsdetektoren detektierten Leistungen werden auf die Gesamtleistung normalisiert, um die relativen Anteile der Polarisationsrichtungen linear horizontal, linear vertikal, linear +45°, linear -45°, rechts- und linkszirkular zu bestimmen. Aus der Verteilung der Anteile kann auf die Polarisationseigenschaften der einfallenden elektromagnetischen Welle geschlossen werden. In Tabelle 1 sind die an der ersten bis sechsten Antenne 1, 2, 3, 4, 5, 6 sowie der optionalen Referenzantenne 9 detektierten Leistungen für die Polarisationszustände einer vollständig polarisierten elektromagnetischen Welle zusammengefasst.

Tabelle 1: Leistungen an der ersten bis sechsten Antennen 1, 2, 3, 4, 5, 6 sowie einer optionalen Referenzantenne 9 bei verschiedenen Polarisationszuständen einer vollständig polarisierten elektromagnetischen Welle

| Antenne/Polarisation | 1 | 2 | 3 | 4 | 5 | 6 | Referenz (optional) |
|---|---|---|---|---|---|---|---|
| Horizontal linear | 1 | 0 | 0,5 | 0,5 | 0,5 | 0,5 | 1 |
| Vertikal linear | 0 | 1 | 0,5 | 0,5 | 0,5 | 0,5 | 1 |
| Linkszirkular | 0,5 | 0,5 | 1 | 0 | 0,5 | 0,5 | 1 |
| Rechtszirkular | 0,5 | 0,5 | 0 | 1 | 0,5 | 0,5 | 1 |
| +45° linear | 0,5 | 0,5 | 0,5 | 0,5 | 1 | 0 | 1 |
| -45° linear | 0,5 | 0,5 | 0,5 | 0,5 | 0 | 1 | 1 |
| Elliptisch | <1 | <1 | <1 | <1 | <1 | <1 | 1 |

Die Polarisation einer elektromagnetischen Welle kann anhand der Richtung und des Drehsinns des elektrischen Feldes dieser elektromagnetischen Welle charakterisiert werden. Der elektrische Feldvektor liegt in einer Ebene senkrecht zur Ausbreitungsrichtung der elektromagnetischen Welle und kann als Linearkombination zweier zueinander orthogonaler Feldkomponenten in dieser Ebene beschrieben werden. In einem kartesischen Koordinatensystem, in dem sich die Welle in z-Richtung ausbreitet, können diese Feldkomponenten, $E_x$ und $E_y$, beispielsweise entlang der positiven x-Achse bzw. der positiven y-Achse des Koordinatensystems orientiert sein:

$$E_x = E_{01} \cos(\omega t + \delta_1) \text{ und } E_y = E_{02} \cos(\omega t + \delta_2) \text{ für } E_z = 0;$$

$E_{01}$ und $E_{02}$ kennzeichnen dabei die Amplituden der Feldkomponenten $E_x$ und $E_y$ parallel zur x-Achse bzw. y-Achse, $\omega$ die Winkelfrequenz und $\delta_1$ und $\delta_2$ die Phasenwinkel der Feldkomponenten $E_x$ und $E_y$. Eine Welle mit der Winkelfrequenz $\omega$ ist vollständig polarisiert, wenn die Feldkomponenten $E_x$ und $E_y$ bei konstanten Amplituden $E_{01}$ und $E_{02}$ eine konstante Phasendifferenz $\delta = \delta_2 - \delta_1$ zueinander aufweisen.

Im allgemeinen Fall beschreibt der Feldvektor in der x-y-Ebene eine Ellipse als Funktion der Zeit, d.h. die elektromagnetische Welle ist elliptisch polarisiert:

$$\left(\frac{E_x}{E_{0x}}\right)^2 + \left(\frac{E_y}{E_{0y}}\right)^2 - 2\left(\frac{E_x E_y}{E_{0x} E_{0y}}\right)\cos\delta = (\sin\delta)^2$$

Sonderfälle treten bei bestimmten Phasendifferenzen bzw. Amplituden auf. Bei einer Phasendifferenz von $\delta = \pm n\pi$ mit n = 0, 1, 2, 3,... ist die Welle linear polarisiert, wobei die Welle bei einer Amplitude von $E_{0y}=0$ horizontal linear polarisiert ist bzw. bei $E_{0x}=0$ vertikal linear polarisiert ist. Sind die Amplituden gleich groß, d. h. $E_{0x}= E_{0y}$, so ist die Welle für $\delta = \pm n\pi$ mit n = 0, 2, 4,... unter einem Winkel von +45° linear polarisiert und für n = 1, 3, 5,... unter einem Winkel von -45° linear polarisiert.

Eine Welle ist zirkular polarisiert, wenn die Amplituden gleich groß sind, d. h. $E_{0x}=E_{0y}$, und die Phasendifferenz $\delta = \pm(n+1/2)\pi$ mit n = 0, 1, 2, 3,... beträgt, wobei rechtszirkulare Polarisation bei $\delta = +(n+1/2)\pi/2$ auftritt und linkszirkulare

Polarisation bei $\delta$ = -(n+1/2)$\pi$ auftritt. Eine polarisierte Antenne 1, 2, 3, 4, 5, 6 kann eine elektromagnetische Welle derselben Polarisation empfangen und in eine elektrische Leistung umwandeln. Die Leistung ist dabei proportional zum Quadrat der Amplitude der elektromagnetischen Welle.

Trifft eine horizontal linear polarisierte elektromagnetische Welle auf eine horizontal linear polarisierte Antenne 1, so kann die Energie der gesamten Welle als Leistung empfangen und detektiert werden. Trifft dagegen eine horizontal linear polarisierte elektromagnetische Welle auf eine vertikal polarisierte Antenne 2, so kann keine Leistung empfangen und detektiert werden, da die Welle keine vertikal polarisierte Komponente aufweist. Analoge Überlegungen gelten für eine vertikal linear polarisierte Welle, die auf eine vertikal bzw. horizontal linear polarisierte Antenne 2, 1 trifft.

Bei einer unter einem Winkel von +45° bzw. -45° polarisierten Antenne 5, 6, setzt sich die empfangene Leistung zu gleichen Teilen aus den Leistungen der horizontal linear und der vertikal linear polarisierten Komponente der elektromagnetische Welle zusammen. Trifft demnach eine horizontal polarisierte elektromagnetische Welle auf eine linear unter einem Winkel von +45° bzw. -45° polarisierte Antenne 5, 6, so wird nur die Hälfte der Leistung empfangen, die eine horizontal polarisierte Antenne 1 empfangen würde, da die elektromagnetische Welle keine vertikale Komponente enthält, die von der +45° bzw. -45° polarisierten Antenne 5, 6 empfangen werden kann. Analoge Überlegungen gelten für eine vertikal polarisierte Welle, die auf eine unter +45° bzw. -45° polarisierte Antenne 5, 6 trifft, und umgekehrt auch für eine unter +45° bzw. -45° polarisierten Welle, die auf eine horizontal bzw. vertikal linear polarisierte Antenne 1, 2 trifft.

Trifft dagegen eine unter einem Winkel von +45° polarisierte elektromagnetische Welle auf eine unter einem Winkeln von +45° polarisierte Antenne 5, so kann die Energie der gesamten Welle als Leistung empfangen werden und am zugehörigen Leistungsdetektor 7 detektiert werden. An einer unter einem Winkel von -45° polarisierten Antenne 6 wird jedoch, analog zum Beispiel der horizontal polarisierten Welle, die auf eine vertikal polarisierte Antenne 2 trifft, keine Leistung empfangen und detektiert. Analoge Überlegungen gelten entsprechend für eine Welle, die unter einem Winkel von -45° polarisiert ist, und auf eine unter -45° bzw. +45° polarisierte Antenne 6, 5 trifft.

Der elektrische Feldvektor einer elektromagnetischen Welle kann statt als Linearkombination aus zwei linearen Feldkomponenten $E_x$ und $E_y$ auch als Linearkombination zweier zirkular polarisierter Feldkomponenten, $E_R$ und $E_L$, die mit konstanten Amplituden gegenläufig zueinander rotieren, beschrieben werden:

$$E_R = \frac{1}{\sqrt{2}} E_x + \frac{i}{\sqrt{2}} E_y \text{ und } E_L = \frac{1}{\sqrt{2}} E_x - \frac{i}{\sqrt{2}} E_y \text{ mit } i^2 = -1$$

wobei für $E_L$=0 eine vollständig rechtszirkular polarisierte Welle vorliegt, und für $E_R$=0 eine vollständig linkszirkular polarisierte Welle vorliegt.

Trifft demnach eine horizontal linear polarisierte elektromagnetische Welle auf eine zirkular polarisierte Antenne 3, 4, so wird von der Antenne 3, 4 nur die Hälfte der Leistung empfangen, die eine horizontal polarisierte Antenne 1 detektieren würde, da die elektromagnetische Welle keine vertikale Komponente $E_y$ enthält. Analoge Überlegungen gelten für eine vertikal polarisierte Welle, die auf eine zirkular polarisierte Antenne 3, 4 trifft, bzw. eine zirkular polarisierte Welle, die auf eine horizontal oder vertikal linear polarisierte Antenne 1, 2 trifft. Trifft eine rechtszirkular polarisierte Welle auf eine rechtszirkular polarisierte Antenne 4, so kann die gesamte Leistung der elektromagnetischen Welle empfangen und detektiert werden, während bei einer linkszirkular polarisierte Welle keine Leistung an einer rechtszirkular polarisierten Antenne 3 empfangen und detektiert wird und umgekehrt.

Bei einer zirkular polarisierten Antenne 3, 4 setzt sich die detektierte Leistung aus den Leistungen der rechtszirkular und linkszirkular polarisierten Komponente der elektromagnetischen Welle zusammen, bei den unter einem Winkel von ±45° polarisierten Wellen aus der horizontal linear und der vertikal linear polarisierten Komponenten der elektromagnetische Welle. Dementsprechend wird an einer zirkular polarisierten Antenne 3, 4, die Hälfte der Leistung einer horizontal oder vertikal polarisierten Welle empfangen, wenn eine unter ±45° polarisierten Wellen auf diese Antenne trifft, und umgekehrt.

Wie dargelegt, kann also je nach Polarisation der einfallenden elektromagnetischen Welle an den sechs Antennen 1, 2, 3, 4, 5, 6 der erfindungsgemäßen Anordnung eine bestimmte Leistung von den Leistungsdetektoren 7 detektiert werden, wobei jede Kombination an Leistungen eindeutig einem Polarisationszustand zuordenbar ist, wie in Tabelle 1 zusammenfassend dargestellt ist. Aus dem Vergleich der detektierten Leistungen kann somit der Polarisationszustand der elektromagnetischen Welle bestimmt werden.

Ist die elektromagnetische Welle bzw. Strahlung, deren Polarisation bestimmt werden soll, teilweise polarisiert, so kann die Polarisation des polarisierten Anteils der elektromagnetischen Welle bzw. Strahlung beispielsweise auch mittels der von G. G. Stokes eingeführten Stokes-Parameter beschrieben werden. Diese Parameter können aus den Leistungen berechnet werden, die an der ersten bis sechsten Antenne 1, 2, 3, 4, 5, 6 detektiert werden, sodass die Vorrichtung eine vollständige Information über die Polarisation liefert. Aus der an der Referenzantenne 9 detektierten Gesamtleistung und den an der ersten bis sechsten Antenne 1, 2, 3, 4, 5, 6 jeweils detektierten Leistungen kann außerdem der Polarisationsgrad der einfallenden elektromagnetischen Welle bzw. Strahlung bestimmt werden.

In Figur 2 ist in einer schematischen Draufsicht die in Figur 1 dargestellte Vorrichtung mit mehreren Antennenanordnungen zur ortsaufgelösten Polarisationsbestimmung dargestellt. Bei der Vorrichtung sind vier Anordnungen von jeweils sechs Antennen 1, 2, 3, 4, 5, 6, jeweils sechs Leistungsdetektoren 7, jeweils einer Referenzantennen 9 und jeweils einem Referenzleistungsdetektor 10 auf einem Substrat 8 angeordnet. Die Auswerteeinheit 12 der Vorrichtung ist ausgebildet, die Polarisation mindestens einer auf die Antennen 1, 2, 3, 4, 5, 6, 9 der vier Anordnungen einfallenden elektromagnetischen Welle bzw. Strahlung ortsaufgelöst in Abhängigkeit von der Position und Orientierung der vier Anordnungen an Antennen 1, 2, 3, 4, 5, 6, 9 und Leistungsdetektoren 7 zu bestimmen.

Im dargestellten Beispiel der Figur 2 sind die vier Anordnungen von Antennen 1, 2, 3, 4, 5, 6, 9 und Leistungsdetektoren 7, 10 jeweils identisch ausgebildet und die Empfangsflächen der Antennen 1, 2, 3, 4, 5, 6, 9 in dieselbe Richtung ausgerichtet. Die vier Anordnungen von Antennen 1, 2, 3, 4, 5, 6, 9 und Leistungsdetektoren 7, 10 sind jeweils 90° zueinander gedreht auf der Oberfläche des Substrates 8 angeordnet, wobei die jeweils erste Antenne 1 und die jeweils zweite Antenne 2 einer Anordnung, d. h. die horizontal und vertikal polarisierten Antennen, ihre Polarisation zyklisch mit der Drehung der jeweiligen Anordnung auf dem Substrat 8 tauschen, und die jeweils fünfte Antenne 5 und jeweils sechsten Antennen 6 einer Anordnung, d. h. die +45° und -45° polarisierten Antennen, ihre Polarisation zyklisch mit der Drehung der jeweiligen Anordnung auf dem Substrat 8 tauschen. Die Vorrichtung ist dadurch sehr kompakt und dazu geeignet, für die typischen Spot-Größen von THz-Strahlung die Polarisationsverteilung innerhalb eines THz-Strahls zu messen.

Lediglich in den Ausführungsbeispielen offenbarte Merkmale der verschiedenen Ausführungsbeispiele können miteinander kombiniert und einzeln, unabhängig vom jeweiligen gezeigten Beispiel, beansprucht werden.

## Patentansprüche

1. Vorrichtung zur Bestimmung der Polarisation elektromagnetischer Wellen aufweisend eine erste Anordnung von mindestens sechs Antennen (1, 2, 3, 4, 5, 6) und mindestens sechs Leistungsdetektoren (7) sowie eine Auswerteeinheit (12), wobei

   jede der sechs Antennen (1, 2, 3, 4, 5, 6) genau einem der sechs Leistungsdetektoren (7) zugeordnet ist,
   die sechs Antennen (1, 2, 3, 4, 5, 6) und die sechs Leistungsdetektoren (7) flächig auf einer Oberfläche eines Substrates (8) angeordnet oder in das Substrat (8) eingebracht sind,
   eine erste Antenne (1) und ein erster Leistungsdetektor (7) ausgebildet sind, bei Bestrahlung der ersten Antenne (1) mit mindestens einer elektromagnetischen Welle die Leistung einer horizontal linear polarisierten Komponente der einfallenden elektromagnetischen Welle zu detektieren,
   eine zweite Antenne (2) und ein zweiter Leistungsdetektor (7) ausgebildet sind, bei Bestrahlung der zweiten Antenne (2) mit der mindestens einen elektromagnetischen Welle die Leistung einer vertikal linear polarisierten Komponente der einfallenden elektromagnetischen Welle zu detektieren,
   eine dritte Antenne (3) und ein dritter Leistungsdetektor (7) ausgebildet sind, bei Bestrahlung der dritten Antenne (3) mit der mindestens einen elektromagnetischen Welle die Leistung einer linkszirkular polarisierten Komponente der einfallenden elektromagnetischen Welle zu detektieren,
   eine vierte Antenne (4) und ein vierter Leistungsdetektor (7) ausgebildet sind, bei Bestrahlung der vierten Antenne (4) mit der mindestens einen elektromagnetischen Welle die Leistung einer rechtszirkular polarisierten Komponente der einfallenden elektromagnetischen Welle zu detektieren, und
   eine fünfte Antenne (5) und ein fünfter Leistungsdetektor (7) ausgebildet sind, bei Bestrahlung der fünften Antenne (5) mit der mindestens einen elektromagnetischen Welle die Leistung einer Komponente der einfallenden elektromagnetischen Welle zu detektieren, deren Polarisationsrichtung linear unter einem Winkel von +45° zur Polarisationsrichtung der vertikal linear polarisierten Komponente der einfallenden elektromagnetischen Welle polarisiert ist,
   eine sechste Antenne (6) und ein sechster Leistungsdetektor (7) ausgebildet sind, bei Bestrahlung der sechsten Antenne (6) mit der mindestens einen elektromagnetischen Welle die Leistung einer Komponente der einfallenden elektromagnetischen Welle zu detektieren, deren Polarisationsrichtung linear unter einem Winkel von -45° zur Polarisationsrichtung der vertikal linear polarisierten Komponente der einfallenden elektromagnetischen Welle polarisiert ist, und
   die Auswerteeinheit (12) ausgebildet ist, aus den detektierten Leistungen der mindestens sechs Antennen (1, 2, 3, 4, 5, 6) die Polarisation der mindestens einen einfallenden elektromagnetischen Welle zu bestimmen.

2. Vorrichtung nach Anspruch 1, **dadurch gekennzeichnet, dass** die Anordnung der mindestens sechs Antennen eine Referenzantenne (9) und einen Referenzleistungsdetektor (10) aufweist, die auf der Oberfläche des Substrats (8) angeordnet oder in das Substrat (8) eingebracht sind, wobei die Referenzantenne (9) und der Referenzleistungsdetektor (10) ausgebildet sind, bei Bestrahlung der Referenzantenne (9) mit mindestens einer elektromagnetischen Welle die Gesamtleistung der einfallenden elektromagnetischen Welle zu detektieren.

3. Vorrichtung nach einem der vorhergehenden Ansprüche, **dadurch gekennzeichnet, dass** die erste Antenne (1), zweite Antenne (2), fünfte Antenne (5) und sechste Antenne (6) als Dipolantennen, bevorzugt als Bow-tie-Antennen, ausgebildet sind, wobei die erste Antenne (1) und die zweite Antenne (2) zueinander orthogonal angeordnet sind, und die fünfte Antenne (5) und die sechste Antenne (6) zueinander orthogonal angeordnet sind, und die erste Antenne (1) und die zweite Antenne (2) paarweise orthogonal zu der fünften Antenne (5) und der sechsten Antenne (6) angeordnet sind.

4. Vorrichtung nach einem der vorhergehenden Ansprüche, **dadurch gekennzeichnet, dass** die dritte Antenne (3) und die vierte Antenne (4) als Spiralantennen mit zueinander entgegengesetztem Drehsinn ausgebildet sind.

5. Vorrichtung nach einem der vorhergehenden Ansprüche, **dadurch gekennzeichnet, dass** die Referenzantenne (9) als elektrisch kleine Antenne ausgebildet ist.

6. Vorrichtung nach einem der vorhergehenden Ansprüche, **dadurch gekennzeichnet, dass** die mindestens sechs Antennen (1, 2, 3, 4, 5, 6) und die sechs Leistungsdetektoren (7) und/oder die Referenzantenne (9) und der Referenzleistungsdetektor (10) ausgebildet sind, bei Bestrahlung mit mindestens einer elektromagnetischen Welle die Leistungen der jeweiligen Komponenten der einfallenden elektromagnetischen Welle in einem Frequenzbereich zwischen 30 GHz bis 5 THz, bevorzugt zwischen 50 GHz und 5 THz, zu detektieren.

7. Vorrichtung nach einem der vorhergehenden Ansprüche, **dadurch gekennzeichnet, dass** die mindestens sechs Antennen (1, 2, 3, 4, 5, 6) und die mindestens sechs Leistungsdetektoren (7) und/oder die Referenzantenne (9) und der Referenzleistungsdetektor (10) ausgebildet sind, bei Bestrahlung mit einer gepulsten elektromagnetischen Wellen die Leistungen der jeweiligen Komponenten der einfallenden gepulsten elektromagnetischen Welle zu detektieren.

8. Vorrichtung nach einem der vorhergehenden Ansprüche, **dadurch gekennzeichnet, dass** die mindestens sechs Leistungsdetektoren (7) und/oder der Referenzleistungsdetektor (10) als Schottky-Dioden-Detektoren ausgebildet sind/ist.

9. Vorrichtung nach einem der vorhergehenden Ansprüche, **dadurch gekennzeichnet, dass** die Vorrichtung mehrere Anordnungen von mindestens sechs Antennen (1, 2, 3, 4, 5, 6) und mindestens sechs Leistungsdetektoren (7) gemäß einem der Ansprüchen 1 bis 8 aufweist, und die Auswerteeinheit (12) ausgebildet ist, die Polarisation mindestens einer einfallenden elektromagnetischen Welle ortsaufgelöst in Abhängigkeit von der Position und Orientierung der Anordnungen der mindestens sechs Antennen (1, 2, 3, 4, 5, 6) zu bestimmen.

10. Verfahren zur Bestimmung der Polarisation einer elektromagnetischen Welle, bei dem eine Vorrichtung nach einem der Ansprüche 1 bis 9 mit mindestens einer elektromagnetischen Wellen bestrahlt wird und

mittels einer ersten Antenne (1) und eines ersten Leistungsdetektors (7), die auf einer Oberfläche eines Substrates (8) angeordnet oder in ein Substrat (8) eingebracht sind, die Leistung einer horizontal linear polarisierten Komponente der einfallenden elektromagnetischen Welle detektiert wird,
mittels einer zweiten Antenne (2) und eines zweiten Leistungsdetektors (7), die auf der Oberfläche des Substrates (8) angeordnet oder in das Substrat (8) eingebracht sind, die Leistung einer vertikal linear polarisierten Komponente der einfallenden elektromagnetischen Welle detektiert wird,
mittels einer dritten Antenne (3) und eines dritten Leistungsdetektors (7), die auf der Oberfläche des Substrates (8) angeordnet oder in das Substrat (8) eingebracht sind, die Leistung einer linkszirkular polarisierten Komponente der einfallenden elektromagnetischen Welle zu detektieren,
mittels einer vierten Antenne (4) und eines vierten Leistungsdetektors (7), die auf der Oberfläche des Substrates (8) angeordnet oder in das Substrat (8) eingebracht sind, die Leistung einer rechtszirkular polarisierten Komponente der einfallenden elektromagnetischen Welle zu detektieren,
mittels einer fünften Antenne (5) und eines fünften Leistungsdetektors (7), die auf der Oberfläche des Substrates (8) angeordnet oder in das Substrat (8) eingebracht sind, die Leistung einer Komponente der einfallenden elektromagnetischen Welle zu detektieren, deren Polarisationsrichtung linear unter einem Winkel von +45° zur Polarisationsrichtung der vertikal linear polarisierten Komponente der einfallenden elektromagnetischen Welle polarisiert ist,

mittels einer sechsten Antenne (6) und eines sechsten Leistungsdetektors (7), die auf der Oberfläche des Substrates (8) angeordnet oder in das Substrat (8) eingebracht sind, die Leistung einer Komponente der einfallenden elektromagnetischen Welle zu detektieren, deren Polarisationsrichtung linear unter einem Winkel von -45° zur Polarisationsrichtung der vertikal linear polarisierten Komponente der einfallenden elektromagnetischen Welle polarisiert ist, und

aus den jeweils detektierten Leistungen der mindestens sechs Antennen (1, 2, 3, 4, 5, 6) mittels einer Auswerteeinheit (12) die Polarisation der einfallenden elektromagnetischen Welle bestimmt wird.

## Claims

1. A device for determining the polarization of electromagnetic waves, comprising a first array of at least six antennas (1, 2, 3, 4, 5, 6) and at least six power detectors (7) as well as an evaluation unit (12),

   each of the six antennas (1, 2, 3, 4, 5, 6) being assigned to exactly one of the six power detectors (7),
   the six antennas (1, 2, 3, 4, 5, 6) and the six power detectors (7) being arranged in a planar manner on a surface of a substrate (8) or introduced into the substrate (8),
   a first antenna (1) and a first power detector (7) being designed, when the first antenna (1) is irradiated with at least one electromagnetic wave, to detect the power of a horizontally linearly polarized component of the incident electromagnetic wave,
   a second antenna (2) and a second power detector (7) being designed, when the second antenna (2) is irradiated with the at least one electromagnetic wave, to detect the power of a vertically linearly polarized component of the incident electromagnetic wave,
   a third antenna (3) and a third power detector (7) being designed, when the third antenna (3) is irradiated with the at least one electromagnetic wave, to detect the power of a left-handed circularly polarized component of the incident electromagnetic wave,
   a fourth antenna (4) and a fourth power detector (7) being designed, when the fourth antenna (4) is irradiated with the at least one electromagnetic wave, to detect the power of a right-handed circularly polarized component of the incident electromagnetic wave, and
   a fifth antenna (5) and a fifth power detector (7) being designed, when the fifth antenna (5) is irradiated with the at least one electromagnetic wave, to detect the power of a component of the incident electromagnetic wave having a polarization direction that is linearly polarized at an angle of +45° with respect to the polarization direction of the vertically linearly polarized component of the incident electromagnetic wave,
   a sixth antenna (6) and a sixth power detector (7) being designed, when the sixth antenna (6) is irradiated with the at least one electromagnetic wave, to detect the power of a component of the incident electromagnetic wave having a polarization direction that is linearly polarized at an angle of -45° with respect to the polarization direction of the vertically linearly polarized component of the incident electromagnetic wave, and
   the evaluation unit (12) being designed to determine the polarization of the at least one incident electromagnetic wave from the detected powers of the at least six antennas (1, 2, 3, 4, 5, 6).

2. The device according to claim 1, **characterized in that** the array of the at least six antennas comprises a reference antenna (9) and a reference power detector (10), which are arranged on the surface of the substrate (8) or introduced into the substrate (8), the reference antenna (9) and the reference power detector (10) being designed, when the reference antenna (9) is irradiated with at least one electromagnetic wave, to detect the overall power of the incident electromagnetic wave.

3. A device according to any one of the preceding claims, **characterized in that** the first antenna (1), second antenna (2), fifth antenna (5), and sixth antenna (6) are designed as dipole antennas, preferably as bow tie antennas, the first antenna (1) and the second antenna (2) being arranged orthogonally with respect to one another, and the fifth antenna (5) and the sixth antenna (6) being arranged orthogonally with respect to one another, and the first antenna (1) and the second antenna (2) being arranged in pairs orthogonally with respect to the fifth antenna (5) and the sixth antenna (6).

4. A device according to any one of the preceding claims, **characterized in that** the third antenna (3) and the fourth antenna (4) are designed as spiral antennas having directions of rotation that are opposite with one another.

5. A device according to any one of the preceding claims, **characterized in that** the reference antenna (9) is designed as an electrically small antenna.

6. A device according to any one of the preceding claims, **characterized in that** the at least six antennas (1, 2, 3, 4, 5, 6) and the six power detectors (7) and/or the reference antenna (9) and the reference power detector (10) are designed, when irradiated with at least one electromagnetic wave, to detect the powers of the respective components of the incident electromagnetic wave in a frequency range between 30 GHz to 5 THz, and preferably between 50 GHz and 5 THz.

7. A device according to any one of the preceding claims, **characterized in that** the at least six antennas (1, 2, 3, 4, 5, 6) and the at least six power detectors (7) and/or the reference antenna (9) and the reference power detector (10) are designed, when irradiated with a pulsed electromagnetic wave, to detect the powers of the respective components of the incident pulsed electromagnetic wave.

8. A device according to any one of the preceding claims, **characterized in that** the at least six power detectors (7) and/or the reference power detector (10) are designed as Schottky diode detectors.

9. A device according to any one of the preceding claims, **characterized in that** the device comprises multiple arrays of at least six antennas (1, 2, 3, 4, 5, 6) and at least six power detectors (7) according to any one of claims 1 to 8, and the evaluation unit (12) is designed to determine the polarization of at least one incident electromagnetic wave in a spatially resolved manner as a function of the position and orientation of the arrays of the at least six antennas (1, 2, 3, 4, 5, 6).

10. A method for determining the polarization of an electromagnetic wave, wherein a device according to any one of claims 1 to 9 is irradiated with at least one electromagnetic wave, and

the power of a horizontally linearly polarized component of the incident electromagnetic wave is detected by means of a first antenna (1) and a first power detector (7), which are arranged on a surface of a substrate (8) or introduced into a substrate (8),

the power of a vertically linearly polarized component of the incident electromagnetic wave is detected by means of a second antenna (2) and a second power detector (7), which are arranged on the surface of the substrate (8) or introduced into a substrate (8),

to detect the power of a left-handed circularly polarized component of the incident electromagnetic wave by means of a third antenna (3) and a third power detector (7), which are arranged on the surface of the substrate (8) or introduced into the substrate (8),

to detect the power of a right-handed circularly polarized component of the incident electromagnetic wave by means of a fourth antenna (4) and a fourth power detector (7), which are arranged on the surface of the substrate (8) or introduced into the substrate (8),

to detect the power of a component of the incident electromagnetic wave, having a polarization direction that is linearly polarized at an angle of +45° with respect to the polarization direction of the vertically linearly polarized component of the incident electromagnetic wave, by means of a fifth antenna (5) and a fifth power detector (7), which are arranged on the surface of the substrate (8) or introduced into the substrate (8),

to detect the power of a component of the incident electromagnetic wave, having a polarization direction that is linearly polarized at an angle of -45° with respect to the polarization direction of the vertically linearly polarized component of the incident electromagnetic wave, by means of a sixth antenna (6) and a sixth power detector (7), which are arranged on the surface of the substrate (8) or introduced into the substrate (8), and

the polarization of the incident electromagnetic wave is determined from the respective detected powers of the at least six antennas (1, 2, 3, 4, 5, 6) by means of an evaluation unit (12).

**Revendications**

1. Dispositif pour déterminer la polarisation d'ondes électromagnétiques présentant une première configuration d'au moins six antennes (1, 2, 3, 4, 5, 6) et d'au moins six détecteurs de puissance (7), ainsi qu'une unité d'évaluation (12), dans laquelle

chacune des six antennes (1, 2, 3, 4, 5, 6) est exactement affectée à un des six détecteurs de puissance (7), les six antennes (1, 2, 3, 4, 5, 6) et les six détecteurs de puissance (7) sont disposés à plat sur une surface d'un substrat (8) ou sont introduits dans le substrat (8),

une première antenne (1) et un premier détecteur de puissance (7) sont conçus pour détecter la puissance d'une composante horizontalement et linéairement polarisée de l'onde électromagnétique incidente lorsque la première antenne (1) est irradiée avec au moins une onde électromagnétique,

une deuxième antenne (2) et un deuxième détecteur de puissance (7) sont conçus pour détecter la puissance d'une composante verticalement et linéairement polarisée de l'onde électromagnétique incidente lorsque la deuxième antenne (2) est irradiée avec au moins une onde électromagnétique,

une troisième antenne (3) et un troisième détecteur de puissance (7) sont conçus pour détecter la puissance d'une composante à polarisation circulaire gauche de l'onde électromagnétique incidente lorsque la troisième antenne (3) est irradiée avec au moins une onde électromagnétique,

une quatrième antenne (4) et un quatrième détecteur de puissance (7) sont conçus pour détecter la puissance d'une composante à polarisation circulaire droite de l'onde électromagnétique incidente lorsque la quatrième antenne (4) est irradiée avec au moins une onde électromagnétique, et

une cinquième antenne (5) et un cinquième détecteur de puissance (7) sont conçus pour détecter, lorsque la cinquième antenne (5) est irradiée par au moins une onde électromagnétique, la puissance d'une composante de l'onde électromagnétique incidente dont la direction de polarisation est linéaire sous un angle de +45° par rapport à la direction de polarisation de la composante verticalement et linéairement polarisée de l'onde électromagnétique incidente,

une sixième antenne (6) et un sixième détecteur de puissance (7) sont conçus pour détecter la puissance d'une composante de l'onde électromagnétique incidente lorsque la sixième antenne (6) est irradiée avec au moins une onde électromagnétique, dont la direction de polarisation est linéaire sous un angle de -45° par rapport à la direction de polarisation de la composante verticalement et linéairement polarisée de l'onde électromagnétique incidente, et

l'unité d'évaluation (12) est conçue pour déterminer la polarisation d'au moins une onde électromagnétique incidente à partir des puissances détectées d'au moins six antennes (1, 2, 3, 4, 5, 6).

2. Dispositif selon la revendication 1, **caractérisé par** une configuration d'au moins six antennes présentant une antenne de référence (9) et un détecteur de puissance de référence (10) disposés à la surface du substrat (8) ou introduits dans le substrat (8), dans laquelle l'antenne de référence (9) et le détecteur de puissance de référence (10) sont conçus pour détecter la puissance totale de l'onde électromagnétique incidente lorsque l'antenne de référence (9) est irradiée avec au moins une onde électromagnétique.

3. Dispositif selon l'une des revendications précédentes, **caractérisé par** une configuration dans laquelle la première antenne (1), la deuxième antenne (2), la cinquième antenne (5) et la sixième antenne (6) sont agencées sous forme d'antennes dipôles, et de préférence sous forme d'antennes papillon, la première antenne (1) et la deuxième antenne (2) sont disposées orthogonalement l'une par rapport à l'autre, la cinquième antenne (5) et la sixième antenne (6) sont disposées orthogonalement l'une par rapport à l'autre, et la première antenne (1) et la deuxième antenne (2) sont disposées orthogonalement sous forme de paires par rapport à la cinquième antenne (5) et à la sixième antenne (6).

4. Dispositif selon l'une des revendications précédentes, **caractérisé par** une configuration dans laquelle la troisième antenne (3) et la quatrième antenne (4) sont agencées sous forme d'antennes spirales au sens de rotation contraire l'une par rapport à l'autre.

5. Dispositif selon l'une des revendications précédentes, **caractérisé par** une configuration dans laquelle l'antenne de référence (9) est agencée sous forme d'antenne électriquement petite.

6. Dispositif selon l'une des revendications précédentes, **caractérisé par** une configuration dans laquelle au moins six antennes (1, 2, 3, 4, 5, 6) et les six détecteurs de puissance (7) et/ou l'antenne de référence (9) et le détecteur de puissance de référence (10) sont agencés pour détecter la puissance des composantes respectives de l'onde électromagnétique incidente sur une plage de fréquences comprise entre 30 GHz et 5 THz, et de préférence entre 50 GHz et 5 THz, lorsqu'elles sont irradiées avec au moins une onde électromagnétique.

7. Dispositif selon l'une des revendications précédentes, **caractérisé par** une configuration dans laquelle au moins six antennes (1, 2, 3, 4, 5, 6), au moins six détecteurs de puissance (7) et/ou l'antenne de référence (9) et les détecteurs de puissance de référence (10) sont conçus pour détecter la puissance des composantes respectives de l'onde électromagnétique pulsée incidente lors d'une irradiation avec une onde électromagnétique pulsée.

8. Dispositif selon l'une des revendications précédentes, **caractérisé par** une configuration dans laquelle au moins six détecteurs de puissance (7) et/ou le détecteur de puissance de référence (10) sont/est agencé/s sous la forme de détecteurs à diode Schottky.

**9.** Dispositif selon l'une des revendications précédentes, **caractérisé par** une configuration dans laquelle le dispositif présente plusieurs configurations d'au moins six antennes (1, 2, 3, 4, 5, 6) et au moins six détecteurs de puissance (7), selon l'une des revendications 1 à 8, et l'unité d'évaluation (12) est conçue pour déterminer la polarisation d'au moins une onde électromagnétique incidente à résolution spatiale en fonction de la position et de l'orientation des arrangements d'au moins six antennes (1, 2, 3, 4, 5, 6).

**10.** Procédé de détermination de la polarisation d'une onde électromagnétique, dans lequel un dispositif selon l'une des revendications 1 à 9 est irradié avec au moins une onde électromagnétique et

au moyen d'une première antenne (1) et d'un premier détecteur de puissance (7) disposés sur une surface d'un substrat (8) ou introduits dans un substrat (8), la puissance d'une composante horizontalement et linéairement polarisée de l'onde électromagnétique incidente est détectée,

au moyen d'une deuxième antenne (2) et d'un deuxième détecteur de puissance (7), disposés sur la surface du substrat (8) ou introduits dans le substrat (8), la puissance d'une composante verticalement linéairement polarisée de l'onde électromagnétique incidente est détectée,

au moyen d'une troisième antenne (3) et d'un troisième détecteur de puissance (7), disposés sur la surface du substrat (8) ou introduits dans le substrat (8), pour détecter la puissance d'une composante à polarisation circulaire gauche de l'onde électromagnétique incidente,

au moyen d'une quatrième antenne (4) et d'un quatrième détecteur de puissance (7), disposés sur la surface du substrat (8) ou introduits dans le substrat (8), pour détecter la puissance d'une composante à polarisation circulaire droite de l'onde électromagnétique incidente,

au moyen d'une cinquième antenne (5) et d'un cinquième détecteur de puissance (7), disposés sur la surface du substrat (8) ou introduits dans le substrat (8), pour détecter la puissance d'une composante du rayonnement électromagnétique incident, dont la direction de polarisation est linéaire à un angle de +45° par rapport à la direction de polarisation de la composante verticalement et linéairement polarisée de l'onde électromagnétique incidente,

au moyen d'une sixième antenne (6) et d'un sixième détecteur de puissance (7), disposés à la surface du substrat (8) ou introduits dans le substrat (8), pour détecter la puissance d'une composante du rayonnement électromagnétique incident dont la direction de polarisation est linéaire à un angle de -45° par rapport à la direction de polarisation de la composante verticalement et linéairement polarisée de l'onde électromagnétique incidente, et dans lequel

la polarisation de l'onde électromagnétique incidente est déterminée à partir des puissances détectées respectives d'au moins six antennes (1, 2, 3, 4, 5, 6) au moyen d'une unité d'évaluation (12).

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3836973 A